# EUROPÄISCHE PATENTANMELDUNG

(11) **EP 0 762 636 A1**
(43) Veröffentlichungstag der Anmeldung: **12.03.1997**
(21) Anmeldenummer: 96111902.1
(22) Anmeldetag: 24.07.1996
(51) Int. Cl.: H03G 3/00

(54) **Vorrichtung und Verfahren zur Verarbeitung von Audiosignalen**

(30) Priorität: 04.09.1995 CH 2500/95
(71) Anmelder: STUDER Professional Audio AG, CH-8105 Regensdorf ZH (CH)
(72) Erfinder: Silvio, Gehri, 8604 Volketswil (CH)

(57) **Zusammenfassung**

Die Erfindung betrifft ein Verfahren und eine Vorrichtung zur Verarbeitung von Audiosignalen wobei die Audiosignale in einem steuerbaren Bauteil (1) verändert werden können. Um auf einfache und kostengünstige Weise Stör- oder Schaltgeräusche zu unterdrücken, wird das Audiosignal anschliessend an die Verarbeitung im Bauteil wahlweise und kurzzeitig gefiltert. Der Übergang zur Filterung kann weiter durch eine Überblendung verbessert werden.

## Beschreibung

Die Erfindung betrifft eine Vorrichtung und ein Verfahren zur Verarbeitung von Audiosignalen mit einem, über eine Steuerschaltung in seiner Wirkung steuerbaren und Schalt- oder Störgeräusche verursachenden Bauteil.

Als Vorrichtung in diesem Sinne ist beispielsweise ein in seinem Ausgangspegel steuerbarer Verstärker anzusehen, dessen Verstärkung K über einen oder mehrere Halbleiterschalter in diskreten Stufen veränderbar ist. Ebenso sind andere Elemente zu verstehen, die ein Audiosignal verarbeiten oder beeinflussen, wobei deren Wirkung über Halbleiterelemente steuerbar ist. Bei solchen Vorrichtungen können die Halbleiterelemente analog oder digital angesteuert sein.

Bei solchen Vorrichtungen bewirkt die Verstellung der Wirkung, also beispielsweise die Änderung der Verstärkung zwangsläufig Schaltgeräusche, die kurzzeitig auftreten und meist deutlich aus dem Audiosignal hervortreten. Solche Schalt- oder Störgeräusche sind insbesondere dann unannehmbar, wenn hohe Anforderungen an die Qualität des Audiosignales gestellt werden.

Solche Schaltgeräusche können zwei verschiedene Ursachen haben. Eine erste Ursache ist die schlagartige Veränderung der Verstärkung, also eine Unstetigkeit im Audiosignal. Wird die Verstärkung dann verändert, wenn das Audiosignal mindestens eine minimale Amplitude erreicht hat, so wird damit die Amplitude schlagartig herauf- oder herabgesetzt. Eine zweite Ursache kann eine schlagartige Ladung oder Entladung zwischen Elementen sein, die als Kondensator wirken. Bei digital arbeitenden Schaltelementen führen Pegel- und Laufzeitänderungen im Audiosignal ebenfalls zu Schaltgeräuschen.

Um diese Schaltgeräusche zu vermelden, ist es heute Stand der Technik, beispielsweise qualitativ hochwertige und kleindimensionierte Bauelemente als Schalter zu verwenden. Diese sind so ausgebildet, dass im Audiosignal nur möglichst kleine Schaltspitzen auftreten können, was durch Miniaturisierung aller Elemente erfolgt, die irgendwie als Kondensator wirken könnten. Nachteilig ist aber der damit verbundene Anstieg des Widerstandes in solchen Bauelementen.
Liegt die erstgenannte Ursache für ein Schaltgeräusch vor, so kann es vermieden werden, indem die Verstärkung nur dann verändert wird, wenn das Audiosignal eine Amplitude mit dem Wert Null oder näherungsweise Null hat, was ja periodisch vorkommt. Schaltungen dazu brauchen aber Platz und können zudem in ihrer Wirkung durch andere äussere Einflüsse beeinträchtigt werden.
Schaltgeräusche werden heute auch dadurch verschleiert, dass man versucht deren maximale Spannung herabzusetzen, was aber nur gelingt, wenn dafür die Zeit, während der sie auftreten, verlängert wird. So dauern die Schaltgeräusche mit verringerter Schaltflankensteilheit länger, treten aber weniger aus dem Audiosignal hervor. Als Nachteil ist hier zu bedenken, dass damit auch das Audiosignal an sich ungünstig beeinflusst wird, denn während dieser oben genannten Zeit stellt sich in stärkerem Masse sogenannter Klirr ein.
Es gibt weitere aufwendige Schaltungen, die zum Ziel haben, die Entstehung von Spannungsspitzen zu vermeiden, die solche Schaltgeräusche verursachen. Nachteilig ist dabei, dass solche Schaltungen teuer sind und ihr Ziel trotzdem nie ganz erreichen.

Es ist deshalb die Aufgabe der Erfindung, wie sie in den Patentansprüchen gekennzeichnet ist, eine solche Vorrichtung zu schaffen, die einfach und billig ist und mit der Schalt- oder Störgeräusche in Audiosignalen wirkungsvoll unterdrückt werden können.

Dies wird dadurch erreicht, dass das Audiosignal anschliessend an die Verarbeitung im steuerbaren Bauteil beim Auftreten eines Störgeräusches kurzzeitig während dessen Dauer gefiltert wird, so dass störende Frequenzen im Hörbereich unterdrückt werden.

Die durch die Erfindung erreichten Vorteile sind darin zu sehen, dass durch die genannte Filterung Schaltgeräusche unterdrückt werden, die eine oder beide der genannten Ursachen haben können. Zudem sind solche Vorrichtungen einfach und billig sowohl in analog arbeitender wie auch in digtal arbeitender Ausführung zu realisieren. Gemäss der Erfindung werden selektiv nur die hörbaren und unerwünschten Effekte unterdrückt, die Ursachen jedoch nicht beseitigt, was es erlaubt, ganz gezielt spezielle Auswirkungen zu dämpfen.

Im folgenden wird die Erfindung anhand von lediglich einen Ausführungsweg darstellenden Figuren erläutert. Es zeigt:
Figur 1 eine analog arbeitende erfindungsgemässe Vorrichtung,
Figur 2 eine digital arbeitende erfindungsgemässe Vorrichtung,
Figur 3 ein zeitlicher Ablauf von Vorgängen,
Figur 4 eine weitere Ausführung der Vorrichtung und
Figur 5 eine weitere schematische Darstellung des zeitlichen Ablaufs der Vorgänge.

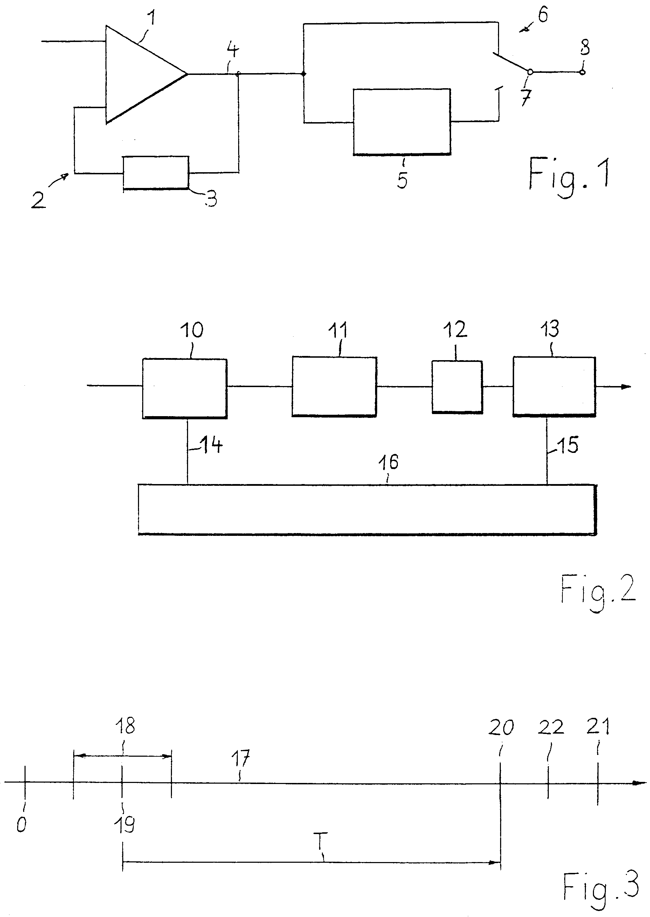

Fig. 1 zeigt als Vorrichtung zur Verarbeitung von Audiosignalen einen analog arbeitenden Verstärker 1 mit einer Rückkopplung 2 und einer steuerbaren Dämpfung 3. An den Ausgang 4 des Verstärkers 1 ist ein Filter 5 angeschlossen, das über einen parallel dazu geschalteten Pfad 6 mit einem steuerbaren Schalter 7 zu- oder weggeschaltet werden kann. An einem Ausgang 8 steht somit wahlweise ein verarbeitetes oder nicht verarbeitetes Audiosignal an.
Die Wirkungsweise dieser Vorrichtung kann beispielsweise so erfolgen, dass ein Audiosignal in den Verstärker 1 gelangt, dort mit einem Faktor K verstärkt wird, was mit der steuerbaren Dämpfung 3 in an sich bekannter Weise eingestellt werden kann, und anschliessend am Ausgang 4 anliegt. Normalerweise gelangt das Audiosignal dann über den Pfad 6 und den Schalter 7 zum Ausgang 8. Wird nun am Verstärker 1 die Dämpfung 3 verändert, so ist mit einem Schaltgeräusch im Audiosignal zu rechnen. Kurz vor der Veränderung des Dämpfung soll nun der Schalter 7 von der gezeigten Stellung in seine andere Stellung umgeschaltet werden, so dass nur das Audiosignal vom Filter 5 an den Ausgang 8 gelangt, wo es beispielsweise von höheren Frequenzen befreit ist. Ist die Veränderung der Dämpfung und somit der Verstärkung abgeschlossen, so kann der Schalter 7 wieder in die gezeigte Stellung gebracht werden und das Audiosignal wird nicht mehr gefiltert. Das Filter 5 ist vorzugsweise als Tiefpassfilter ausgebildet. Die Grenzfrequenz des Tiefpassfilters ist vorzugsweise so gewählt, dass das Schaltgeräusch für das Gehör weitgehend herausgefiltert, die globale Lautstärke des Audiosignals aber so wenig wie möglich verändert ist.

Fig. 2 zeigt als Vorrichtung zur Verarbeitung von Audiosignalen ein analog arbeitendes Bauteil 10, das Schaltgeräusche verursachen kann. Daran angeschlossen ist möglicherweise ein weiteres analog arbeitendes Bauteil 11, ein Analog/Digital-Wandler 12 und ein digital arbeitender Signalprozessor 13. Alle diese Elemente sind in Serie geschaltet. Verbindungen 14 und 15, die beispielsweise als Bus ausgebildet sein können, verbinden das Schaltelement 10 und den Signalprozessor 13 mit einer beispielsweise digital arbeitenden Steuerschaltung 16. Der Signalprozessor 13 enthält dabei die notwendigen Bauelemente und Programme gespeichert, die für eine an sich bekannte digitale Filterung des Audiosignales notwendig sind.
Die Wirkungsweise dieser Schaltung wird anschliessend auch mit Bezug auf Fig. 3 erläutert. Wird im Bauteil 10 durch Betätigung eines Schaltelementes zur Zeit 0 längs der Zeitachse 17 ein Vorgang ausgelöst, der ein Stör- oder Schaltgeräusch verursachen könnte, so wird dies der Steuerschaltung 16 über die Leitung 14 mitgeteilt. Der Vorgang kann aber auch von der Steuerschaltung 16 über die Leitung 14 ausgelöst sein. Das Audiosignal wandert nun über die Elemente 11 und 12 zum Signalprozessor 13, wobei es eine gewisse Zeit T, braucht bis es beim Signalprozessor 13 eintrifft. Diese Zeit T ist weitgehend durch die Laufzeit im A/D-Wandler 12 bestimmt und kann von der Abtastfrequenz abhängig sein. Die Zeit T wird im Signalprozessor 13 berücksichtigt, indem dieser für den Beginn der Filterung den Ablauf einer von der Zeit T abhängigen Wartezeit abwartet. Um die variable Laufzeit des Audiosignales im A/D-Wandler auszugleichen, kann dem Signalprozessor eine Information über die aktuelle Laufzeit im A/D-Wandler mitgeteilt werden. Dies kann vorzugsweise dadurch geschehen, dass die Abtastrate des A/D-Wandlers mit der Taktfrequenz des Signalprozessors synchronisiert wird. Weiter ist es möglich, dass die Ausgabe des Steuersignales über die Leitung 15 an den Signalprozessor 13 durch die Steuerschaltung 16 verzögert erfolgt, weil beispielsweise diese noch andere Aufgaben zu bewältigen hat, die Vorrang haben. Dieser Umstand wird durch den Bereich 18 dargestellt, in dem die Zeit 19 liegt, zu der die Meldung an den Signalprozessor 13 tatsächlich erfolgt. Zur Zeit 20 kann das Filter im Signalprozessor 13 aktiviert werden. Bis zur Zeit 21 bleibt es auch aktiviert. Im Zeitraum zwischen den Zeiten 20 und 22 kann auch ein Überblendvorgang stattfinden. Mit 22 ist diejenige Zeit angegeben, zu der das Schaltgeräusch im Signalprozessor 13 erwartet wird und die Filterung sicher aktiv sein muss. Es versteht sich, dass die Zeit, während der das Audiosignal gefiltert ist, möglichst kurz sein soll. Das ist dann erreichbar, wenn der Bereich 18 klein gehalten und die Varianz der Laufzeit des Audiosignals im A/D-Wandler kompensiert wird.

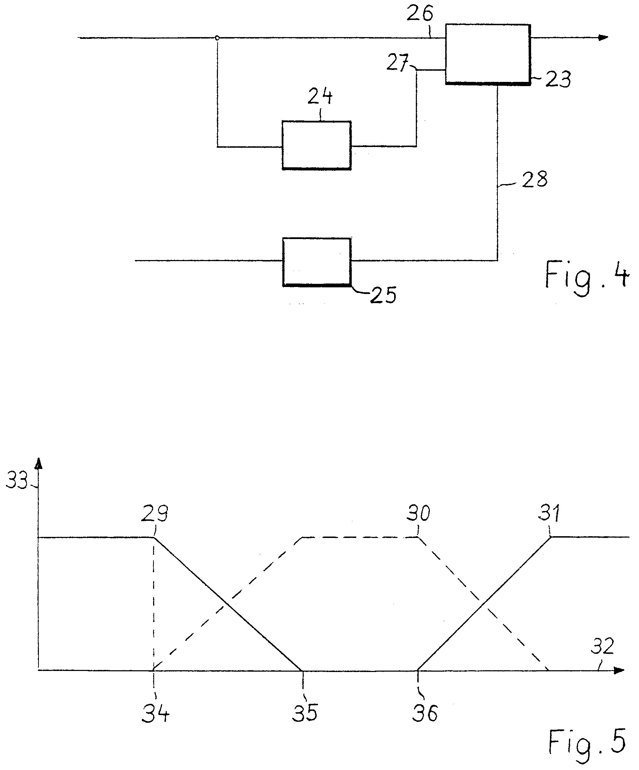

Fig. 4 zeigt eine weitere Ausführung der erfindungsgemässen Vorrichtung, wie sie beispielsweise in einem digitalen Signalprozessor realisiert sein kann. Diese weist eine Überblendeinheit 23, ein Filter 24 und eine Steuereinheit 25 auf. Dabei hat die Überblendeinheit 23 zwei Eingänge 26 und 27, wobei am Eingang 26 das ungefilterte Audiosignal und am Eingang 27 das gefilterte Audiosignal anliegt. Die Überblendeinheit 23 hat auch eine Verbindung 28 zur Steuereinheit 25.
Die Wirkungsweise ist dabei die folgende:
Solange kein Schaltgeräusch zu erwarten ist, wird das Audiosignal unverändert durchgelassen. Ist aber ein Schaltgeräusch zu erwarten, so findet beim Umschalten vom Signal vom Eingang 26 auf das Signal vom Eingang 27 eine Überblendung statt. In Fig. 5 kann dies an den Signalverläufen 29, 30 und 31 dargestellt werden, die über einer Zeitachse 32 und neben einer Achse 33 aufgetragen sind, auf der Werte für die Verstärkung bzw. Dämpfung aufgetragen sind. Das Signal aus dem Eingang 26 wird von einer Zeit 34 an kontinuierlich beispielsweise gemäss dem Signalverlauf 29 bedämpft, wobei gleichzeitig das Signal vom Eingang 27 kontinuierlich gemäss dem Signalverlauf 30 stärker durchgelassen wird. Zu einer Zeit 35 und später wird nur noch das gefilterte Signal 30 aus dem Eingang 27 durchgelassen. Zwischen den Zeiten 34 und 35 werden beide Signale aus den Eingängen 26 und 27 miteinander vermischt, so dass kein abrupter Wechsel erfolgt. Der umgekehrte Vorgang findet entsprechend nach der Zeit 36 statt. Für diese Vorgänge, der abnehmenden und ansteigenden Dämpfung weist die Überblendeinheit 23 die an sich bekannten Bausteine für digitale Signalverarbeitung auf, die von der Steuereinheit 25 angesteuert werden. Diese gibt insbesondere auch in an sich bekannter Weise die Koeffizienten für die Filterung aus.

Das erfindungsgemässe Verfahren und die Vorrichtung eignen sich nicht nur zur Verdeckung von Schaltgeräuschen, sondern eines weiten Bereiches von kurzzeitigen Störungen, die im Hörbereich liegen. Dazu muss aber das zeitliche Auftreten des Stör- oder Schaltgeräusches zeitlich voraussehbar sein.

## Patentansprüche

1. Vorrichtung zur Verarbeitung von Audiosignalen mit einem, über eine Steuerschaltung (3) in seiner Wirkung steuerbaren und Schalt- oder Störgeräusche verursachenden Bauteil (1), dadurch gekennzeichnet, dass dem steuerbaren Bauteil über seinen Ausgang (4) ein zwischen zwei Stellungen umschaltbarer Schalter (7) zugeordnet ist, mit dem in der einen Stellung das Audiosignal unverändert an einen Ausgang (8) der Vorrichtung abgegeben und in der anderen Stellung das Audiosignal kurzzeitig über ein Filter (5) dem Ausgang (8) zugeleitet wird.

2. Vorrichtung nach Anspruch 1, dadurch gekennzeichnet, dass das Filter ein Tiefpassfilter ist

3. Vorrichtung nach Anspruch 1, dadurch gekennzeichnet, dass der Schalter als Überblendeinheit (23) ausgebildet ist.

4. Vorrichtung nach Anspruch 1, dadurch gekennzeichnet, dass Filter und Überblendeinheit Teil eines digital arbeitenden Signalprozessors (13) sind.

5. Vorrichtung nach Anspruch 4, dadurch gekennzeichnet, dass die Taktfrequenz des Signalprozessors mit der Abtastfrequenz eines dem Signalprozessor vorgeschalteten A/D-Wandlers (12) für das Audiosignal synchron ist.

6. Verfahren zur Verarbeitung von Audiosignalen, wobei die Audiosignale in einem steuerbaren Bauteil verändert werden, dadurch gekennzeichnet, dass das Audiosignal anschliessend an die Verarbeitung im Bauteil wahlweise und kurzzeitig gefiltert wird, um Schalt- oder Störgeräusche im Hörbereich zu unterdrücken.

7. Verfahren nach Anspruch 6, dadurch gekennzeichnet, dass die Filterung nur dann erfolgt, wenn ein Schaltgeräusch im Audiosignal auftritt.

8. Verfahren nach Anspruch 6, dadurch gekennzeichnet, dass bei der Filterung Signalteile mit höheren Frequenzen im Hörbereich herausgefiltert werden.

9. Verfahren nach Anspruch 6, dadurch gekennzeichnet, dass der Filterung nachfolgend eine Überblendung des gefilterten Signals mit dem ungefilterten Signal erfolgt.
